# EUROPEAN PATENT APPLICATION

(11) **EP 1 022 352 A2**
(43) Date of publication of application: **26.07.2000**
(21) Application number: 99125723.9
(22) Date of filing: 23.12.1999
(51) Int. Cl.: C23C 14/32, H01L 21/3205, H01L 21/768, H01L 21/285

(54) **Method for forming metal interconnects with increased electromigration lifetime**

(30) Priority: 28.12.1998 US 221091
(71) Applicant: Infineon Technologies North America Corp., San Jose, CA 95112-6000 (US); International Business Machines Corporation, Armonk, NY 10504 (US)
(72) Inventor: Schnabel, Rainer Florian, 85635 Höhenkirchen (DE); Hoinkis, Mark, Fishkill, NY 12590 (US); Iggulden, Roy, Newburgh, NY 12550 (US); Clevenger, Lawrence, LaGrangeville, NY 12540 (US); Filippi, Ronald, Wappingers Falls, NY 12590 (US); Weber, Stefan, Fishkill, NY 12524 (US); Weigand, Peter, 82008 Unterhaching (DE)
(74) Representative: Patentanwälte Westphal, Mussgnug & Partner

(57) **Abstract**

A reliable interconnect for semiconductor integrated circuits is provided. The interconnect comprises a conductor and a liner formed thereunder by an ionized metal plasma physical vapor deposition process. The liner reduces the angular distribution as well as reducing the size of the grains in the conductor, which results in an increase in electromigration lifetime.

## Description

### FIELD OF THE INVENTION

The invention relates to semiconductor devices and more particularly, to increasing electromigration lifetime of conductors in the semiconductor devices.

### BACKGROUND OF THE INVENTION

Fabrication of semiconductor devices includes layers of metal interconnects above the active areas of the devices. A common failure mode over the lifetime of a semiconductor device is failure due to electromigration of conductor materials. Electromigration involves the migration of metal atoms along the length of metallic conductors carrying large direct current densities.

A semiconductor chip typically has a cumulative length of several meters of aluminum (Al) interconnect stripes. The Al interconnects are typically in the order of about a micron in width and thickness. At high current densities the metal atoms of the interconnects experience mass transport thereby moving atoms from their normal positions and depositing them in other positions. Mass transport effects are manifested by void formation, mass pileups and hillocks, cracked dielectric film over layers, grain boundary grooving, localized heating and thinning along interconnects and near contacts. Mass transport effects may result in material from one interconnect extending to another interconnect resulting in a short circuit. Also, short circuits and/or performance degradation may occur when voids due to electromigration cause a break in an interconnect or contact.

Electromigration lifetime may be defined as the mean time to failure (MTF) of a device by the failure mode of electromigration. To increase the electromigration lifetime, the use of redundant layers may be employed. Redundant layers are typically manifested as liners or wetting of a material other than Al to prevent the mass transport of the Al. Redundant layers of titanium compounds, such as Ti and Ti/N, have shown a great reduction in mass transport due to electromigration.

Sidewall interfaces of the Al interconnects to the surrounding dielectric (silicon dioxide) and Al grain boundaries have been identified as main material transport paths formed by metal subtraction after the metal deposition process. A physical vapor deposition process (PVD), such as, collimated or uncollimated PVD, may be performed to sputter a liner of Ti and/or Ti/N onto the surrounding dielectric of an interconnect site. The interconnect may then be deposited onto the liner. In this way, the amount of mass transport is significantly reduced. However, with shrinking lateral and vertical dimensions between interconnect lines, prevention of electromigration mass transport becomes even more challenging.

Therefore, a need exists for a method of reducing mass transport due to electromigration and thereby increases the electromigration lifetime of semiconductor devices.

### SUMMARY OF THE INVENTION

A semiconductor device including interconnects which have increased reliability. Liner and a conductor layers are formed on a substrate and patterned to form a conductor having its bottom surface lined with the liner. In one embodiment, the liner is deposited by an ionized metal plasma physical vapor deposition process. Such a process reduces the angular distribution and the size of the grains in the conductor, resulting in an increase in electromigration lifetime.

### BRIEF DESCRIPTION OF DRAWINGS

FIGS. 1 - 5 show a cross sectional view of a portion of a semiconductor chip having a conductor made in accordance with one embodiment of the invention;
FIG. 6 is a simplified view of prior art grain boundaries in a liner and a metal in contact;
FIG. 7 is a simplified view of grain boundaries in accordance with the present invention showing reduced angular displacement; and
FIG. 8 is a log-log plot showing increased electromigration life for semiconductor devices fabricated in accordance with the present invention.

### DETAILED DESCRIPTION OF THE INVENTION

This disclosure relates to semiconductor devices and more particularly, to increasing electromigration lifetime of conductors in the semiconductor devices. In accordance with the invention, a liner is used to reduce the angular distribution of the grains of the conductor material, in order to result in an increase in the electromigration lifetime of the conductor.

In one embodiment, an ionized metal plasma physical vapor deposition (I-PVD or IMP) process is employed to deposit the liner. Depositing the liner by IMP causes the atoms of the liner to form grains that are highly oriented. When a metal interconnect is deposited, the metal of the interconnect also is highly oriented due to the liner. This produces a very small angular distribution between the liner metal and the interconnect metal as well as smaller grains in the conductor, thereby increasing the life of the device.

To facilitate discussion, the invention is described in the context of a connector interconnecting a bit line of, for example, a memory integrated circuit (IC). However, the invention is broader and is applicable to semiconductor ICs subject to electromigration. The ICs, for example, include various types of memory ICs such as random access memories (RAMs), dynamic random access memories (DRAM), synchronous DRAMs (SDRAMs), video random access memories (VRAMs) or read only memories (ROMs). Devices such as application specific ICs (ASICs), merged DRAM-logic circuits (embedded DRAMs), processor ICs, or any other logic circuits are also applicable. Typically, the devices are used in, for example, consumer products such as computer systems, cellular phones, personal digital assistants (PDAs), and other electronic products.

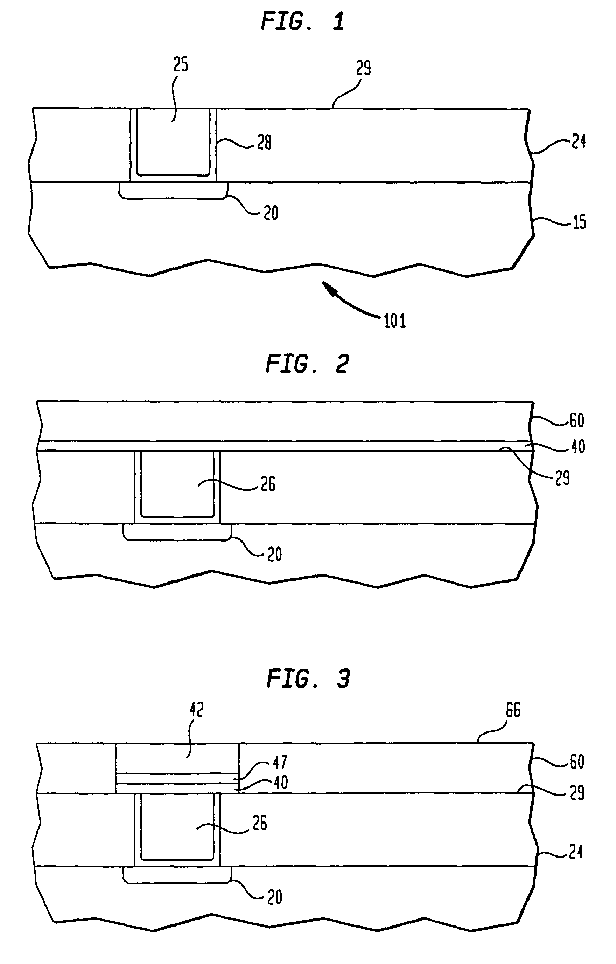

Referring to FIG. 1, a cross sectional view of an integrated circuit structure 101 is shown. As shown, the structure comprises a substrate 15, such as a silicon wafer. Other semiconductor substrates such as gallium arsenide, germanium, silicon on insulator (SOI), or other semiconductor materials are also useful. The substrate, for example, may be lightly or heavily doped with dopants to achieve the desired electrical characteristics.

The substrate 15 includes features (not shown in detail) formed in and/or on the substrate. The features correspond to devices that form an IC. Included on the IC is a previously defined device layer 20 wherein contact with another conductive layer is desired. Although the device layer, for purposes of illustration, is depicted as being spatially above the features, it is understood that it may be located within the same layer. Device layer 20, for example, represents a portion of an underlying metallization layer. Alternatively, the device layer is a highly doped silicon, polysilicon layer, or a portion of any type of an active device such, for example, the source or drain region of a transistor. In one embodiment, device layer 20 represents a bit line of a DRAM IC.

A dielectric layer 24 is formed on substrate 15. The dielectric layer is patterned to form a contact hole 26 using conventional techniques. Conductive material 25 is then deposited over the dielectric layer, filling the contact hole and covering the dielectric layer. The sides and bottom of the contact hole may be lined with a material 28 to improve filling of the contact hole. Excess material is then polished away from a surface 29 to create a planar surface for additional layers. A contact is formed thereby, which is electrically coupled to the device layer 20.

Referring to FIG. 2, a conductor is formed coupled to the contact 26. The conductor, for example, represents a bit line of a memory IC. In accordance with the invention, a liner 40 is deposited on the dielectric surface 29. The liner comprises a material having high electromigration resistance. Such liner material includes, for example, titanium (Ti) and its alloys, tantalum (Ta) and its alloys, or TiN or TaN. Other transitional metals and their nitride such as niobium, tantalum (Ta) and its alloys, or TiN or TaN. Other transitional metals and their nitride such as niobium, niobium nitride, molybedenum, and molybedenum nitride may also be used. In one embodiment, the liner comprises Ti.

The liner is deposited using an ionized metal plasma physical vapor deposition process (IMP). IMP is dcscribed in, for example, US Patent 5,670,415 which is herein incorporated by reference for all purposes. The IMP is performed in a reaction chamber where compounds are introduced. The compounds react to form the layer. Typical IMP conditions include energizing, for example, Ti compounds in a electric field of about 1 to 10 eV. The temperature of the reaction is maintained at about 0 to 400°C, preferably at about 0 to 100°C. Higher temperatures are contemplated as well, for example greater than 400°C. The pressure is maintained from about 1 x 10⁻⁹ mtorr to about atmospheric pressure, preferably about 1 x 10⁻⁸ to 1 x 10⁻⁷ mtorr.

The liner should be sufficiently thick enough to reduce the angular distribution of the grains in the subsequently deposited conductor material to increase its electromigration lifetime. Typically, the thickness of the liner is about 10 - 1000 Å, preferably about 100 - 800 Å. The thickness may be optimized for specific applications, such as, for example, to achieve low sheet resistance.

The IMP process may optionally be followed by an anneal to further orient the grains of the liner material. The anneal, for example, is performed at a temperature of about 200 to 500°C for about 10 seconds to 60 minutes.

A conductive layer 60 is deposited after the formation of the liner 40. The conductive layer, for example, comprises Al, Cu, or W or their alloys. Other conductive materials such as Al Cu Si or other alloys are also useful. Typically, Al Cu Si includes small percentage (by weight) of Cu and Si, for example ≤ 5% Cu and Si combined. In one embodiment, the conductive layer comprises an AL/CU alloy. The AL/CU alloy comprises a small amount of Cu, for example, about 0.5% Cu by weight.

Alternatively, the conductive layer 60 comprises a plurality of layers, forming a film stack. For example, the conductive layer may comprise combinations of conductive layers formed from materials, such as Cu, Au, Ag, Ni, Pt, Pd, V, Nb, W, Ta, Ti, and their alloys (CuAl, CuAg3, TaN, TaN, and the like).

Typically, the conductive layer is deposited by physical techniques such as sputtering, or physical vapor deposition (PVD). Other techniques, such as CVD, high pressure fill, or hollow cathode sputtering, are also useful.

The thickness of the conductive layer depends on various design parameters, such as resistance. It is desirable to have a low sheet resistance as this increases performance. The sheet resistance is determined by the cross-section of the conductor, taking the liner layer, into consideration. The greater the area of the cross-section, the lower the sheet resistance. As such, the height (thickness) and width of the cross-section can be varied to result in a conductor that does not exceed the specified sheet resistance. The width of the conductor is limited by lithographic ground rule (GR). For GR of 0.25 um with 0.5 um pitch, typical thickness of the conductor is about 1000 - 6000 Å, and preferably about 2300 - 3700 Å.

Referring to FIG. 3, the conductor layer is patterned to form a conductor 42. Patterning includes, for example, depositing a photoresist layer and selectively exposing it with an exposure source using a mask. Depending on whether a positive or negative resist is used, the exposed or unexposed portions of the resist are removed during development. After development, the portion of the resist remaining serves as an etch mask, protecting the conductor region from being etched. An anisotropic etch, such as a RIE, removes the unprotected portions of the conductor layer, leaving conductor 42. The RIE removes portions of the liner in the unprotected regions as well. To improve lithographic resolution, an anti-reflective coating (ARC) layer is deposited prior to the deposition of the resist layer. The ARC can be removed or left on the surface of the conductor.

An insulator layer 60 is formed over the substrate, covering the conductor 42. The insulator layer serves, for example, as an interlevel dielectric that isolates the device features from a conductive layer.

The insulator layer comprises a dielectric material such as silicon oxide. Materials such as doped silicate glass including phosphosilicate glass (PSG), borosilicate glass (BSG), or borophosphosilcate glass (BPSG) are also useful. Other insulator material may also include, for example, a polymer like polyimide. The insulator layer can be deposited by, for example, chemical vapor deposition (CVD) or other deposition techniques. The insulator layer is sufficiently thick to cover the conductor 42. The substrate is polished by, for example, a chemical mechanical polish (CMP). The top surface of the conductor serves as a CMP stop, resulting in a planar top surface 66 with the conductor 42 exposed.

Interaction of the conductor material with the liner 40 may be a concern in some applications. In such applications, a barrier layer 41 may be employed. The barrier is deposited over the liner 40 prior to depositing the conductor material. The barrier layer comprises a material that prevents atoms from the liner or conductor from diffusing though to contact each other. In one embodiment, the barrier comprises Ti/N. Other barrier materials may include Ta or Ta/N. The Ti/N is sufficiently thick to serve as a barrier layer and less than that which inhibits the liner from effecting a high grain orientation in the conductor material. Typically, the barrier layer is about 10 - 1000 Å.

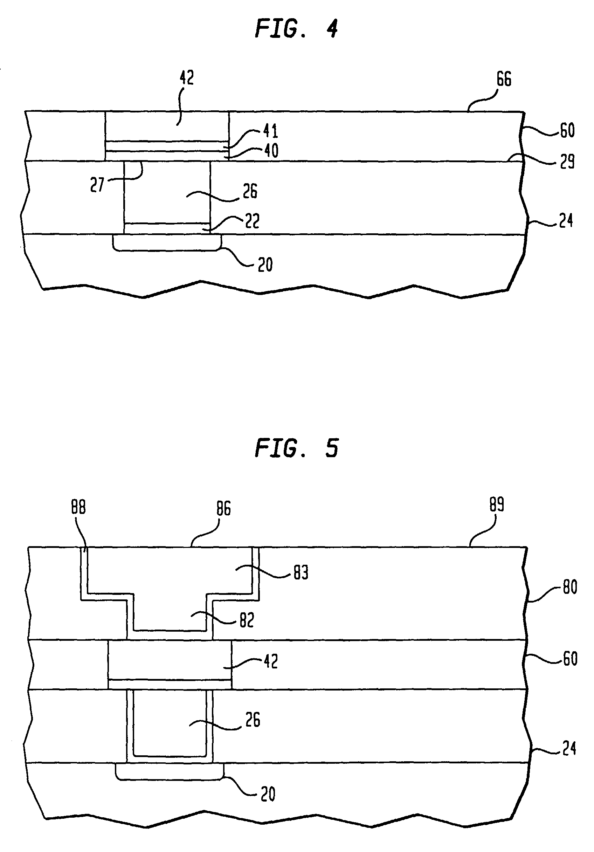

Referring to FIG. 4, the contact 26 is formed similarly to the conductor 42. For example, liner 22 and conductive layer 26 are deposited and patterned form a stud, which is then covered with a dielectric layer 24. A polish is performed to remove the excess dielectric layer to expose the top surface 27 of the contact stud, resulting in the contact 26.

Processing continues to form a global interconnection of the DRAM IC. Referring to FIG. 5, the global interconnection 86 comprises, for example, a dual damascene structure 86 formed and filled using conventional techniques. Such techniques are described in, for example, Licata et al., VLSI Multilayer Interconnection Conf. Proceedings (1995); and Edelstein et al. IEDM Conf. (1997), which are herein incorporated by reference for all purposes.

In one embodiment, the dual damascene is formed by depositing a dielectric layer 80 and selectively patterning it to form a via portion 82 to contact the conductor 54 and a trench portion 83. Formation of the via and trench portions may require one or more lithographic and etch processes. A conductive material is then deposited to fill the damascene structure and covering the dielectric layer. A liner 88 may be formed to improve filling of the damascene structure, as known in the art. Excess material is then polished away to create global interconnect 86 and a planar surface 89 for additional layers. Additional processing is performed to complete the IC. For example, such processing includes forming a passivation layer, contents and final packaging.

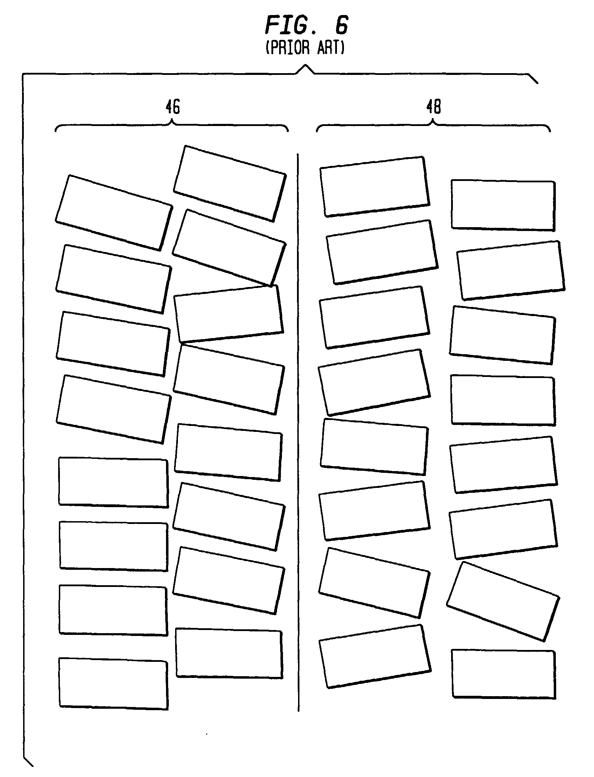

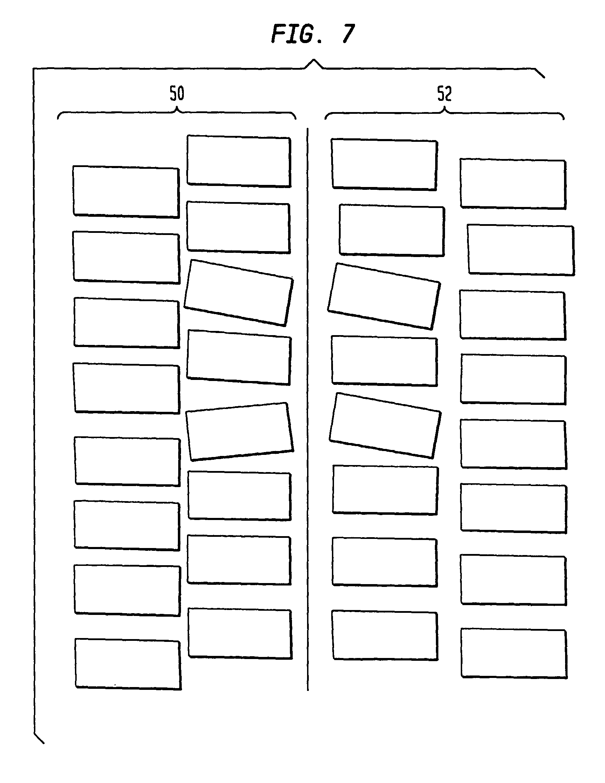

Referring to FIG. 6, a prior art illustration of grain boundaries is shown. Grain boundaries for liner grains 46 have a greater angular distribution on average with contact or interconnect grains 48 as compared to FIG. 6. FIG. 7 illustrates the reduction of angular distribution between grain boundaries of grains 50 of liners 28, 32 and 42 with respect to grains 52 of contacts 26 and interconnects 34 and 44. By reducing angular distribution, a highly oriented relationship results between the grains 50 of liners 28, 32 and 42 and the grains 52 of contacts 26 and interconnects 34 and 44, thereby reducing mass transport probability due to electromigration.

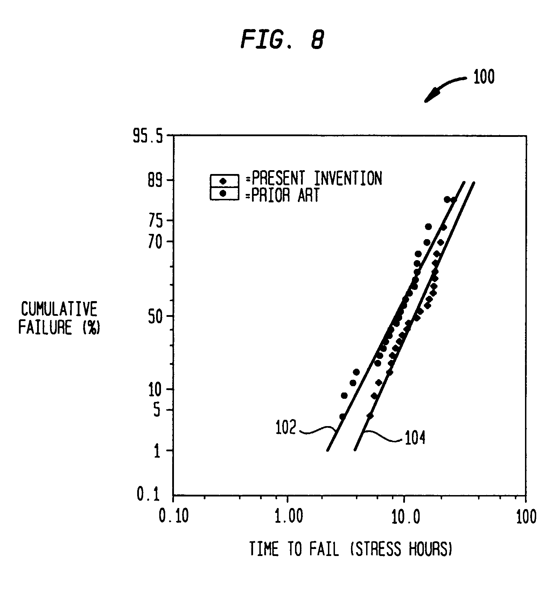

Referring to FIG. 8, experimental results are shown in graph 100. An experiment using structures in accordance with the present invention was conducted at a temperature of about 250°C and a current of about 0.81 mA to produce a current density of about 0.1 to about 10 mA/mm². Liners of Ti/N around Al interconnects were used in the experiment. The samples for the experiment were divided into two groups: 1) liners produced by prior art PVD and 2) liners produced in accordance with the present invention. Data collected from each sample was used to plot curves on a log-log scale. The x-axis represents Time to Failure in stress hours, and the y-axis represents the cumulative failure percent. A shift to the right on the x-axis of indicates an increase in electromigration lifetime.

Actual data for conventional liners are plotted as circles and best fit with curve 102. Actual data for liners in accordance with the present invention are plotted as diamonds and best fit with curve 104. It is apparent that the electromigration lifetime is significantly increased as a result on the process of the current invention. Curve 104 is shifted to the right of curve 102 indicating an increase time to fail. This increase is realized over the entire range of cumulative failure percentages.

While the invention has been particularly shown and described with reference to various embodiments, it will be recognized by those skilled in the art that modifications and changes may be made to the present invention without departing from the spirit and scope thereof. The scope of the inventicn should therefore be determined not with reference to the above description but with reference to the appended claims along with their full scope of equivalents.

## Claims

1. A method for increasing electromigration lifetime in a metal interconnect comprising:
depositing a liner by ionized metal plasma physical vapor deposition (IMP); and
depositing the metal interconnect over the liner, wherein the liner reduces the angular distribution the grains of the metal interconnect to increase electromigration lifetime.

2. The method as recited in claim 1 wherein the liner comprises a material having high electromigration resistance.

3. The method as recited in claim 2 wherein the liner comprises a transitional metal.

4. The method as recited in claim 2 wherein the liner comprises a nitride of a transitional metal.

5. The method as recited in claim 4 wherein the transitional metal is selected from the group comprising titanium, tantalum, niobium, and molybedenum.

6. The method as recited in claim 2 wherein the liner comprises titanium or tantalum.

7. The method as recited in claim 2 wherein the liner comprises an alloy or a nitride of titanium or tantalum.

8. The method as recited in claim 2 wherein the IMP deposits the liner with an electric field of about 1 to 10 eV.

9. The method as recited in claim 2 wherein the IMP deposits the liner at a temperature of about 0 to 400°C.

10. The method as recited in claim 2 wherein the IMP deposits the liner at a temperature of about 0 to 100°C.

11. The method as recited in claim 2 wherein the IMP deposits the liner at a pressure of about 1 x 10⁻⁹ mtorr to about atmosphere.

12. The method as recited in claim 2 wherein the IMP deposits the liner at a pressure of about 1 x 10⁻⁸ to 1 x 10 ⁷ mtorr.

13. The method as recited in claim 2 wherein the liner is deposited with a thickness sufficient to reduce the angular distribution of the grains in the subsequently deposited conductor material to increase its electromigration lifetime.

14. The method as recited in claim 13 wherein the thickness of the liner is about 10 - 1000 Å.

15. The method as recited in claim 13 wherein the thickness of the liner is about 100 - 800 Å.

16. The method as recited in claim 2 further comprises annealing the liner after it has been deposited.

17. The method as recited in claim 16 wherein the anneal is performed at a temperature of about 200 to 500°C.

18. The method as recited in claim 16 wherein the anneal is performed for about 10 seconds to 60 minutes.
